# EUROPEAN PATENT APPLICATION

(11) **EP 4 102 581 A1**
(43) Date of publication of application: **14.12.2022**
(21) Application number: 21750168.3
(22) Date of filing: 02.02.2021
(51) Int. Cl.: H01L 35/30, H02N 11/00

(54) **THERMOELECTRIC CONVERSION STRUCTURE**

(30) Priority: 07.02.2020 JP 2020019966
(71) Applicant: Mitsubishi Materials Corporation, Tokyo 100-8117 (JP)
(72) Inventor: ARAI, Koya, Saitama-shi, Saitama 330-8508 (JP)
(74) Representative: Hoffmann Eitle
(86) International application number: PCT/JP2021/003712
(87) International publication number: WO 2021/157565

(57) **Abstract**

This thermoelectric conversion structure has a heat source and a thermoelectric conversion module installed at the heat source, where the thermoelectric conversion module has a plurality of thermoelectric conversion elements, a first electrode portion disposed on one end side of the thermoelectric conversion elements, and a second electrode portion disposed on the other end side of the thermoelectric conversion elements, and has a structure in which the plurality of thermoelectric conversion elements are electrically connected to each other via the first electrode portion and the second electrode portion, and at least a first electrode portion side of the thermoelectric conversion module, facing a heat source direction, has a structure that is free of fixation and free of restraint.

## Description

### TECHNICAL FIELD

The present invention relates to a thermoelectric conversion structure that carries out mutual conversion between thermal energy and electric energy.

Priority is claimed on Japanese Patent Application No. 2020-019966, filed February 7, 2020, the content of which is incorporated herein by reference.

### BACKGROUND ART

A thermoelectric conversion element is an electronic element that enables mutual conversion between thermal energy and electric energy by the Seebeck effect or the Peltier effect.

The Seebeck effect is a phenomenon in which an electromotive force is generated when a temperature difference is generated between both ends of a thermoelectric conversion element, and thermal energy is converted into electric energy. The electromotive force generated by the Seebeck effect is determined by the characteristics of the thermoelectric conversion element. In recent years, thermoelectric power generation utilizing this effect has been actively developed.

The Peltier effect is a phenomenon in which a temperature difference is generated at both ends of a thermoelectric conversion element when an electrode or the like is formed at both ends of the thermoelectric conversion element and a potential difference is generated between the electrodes, and electric energy is converted into thermal energy. An element having this effect is particularly called a Peltier element, and is used for cooling and temperature control of precision instruments and small refrigerators.

As a thermoelectric conversion module using the above-described thermoelectric conversion element, for example, a structure in which n-type thermoelectric conversion elements and p-type thermoelectric conversion elements are alternately connected in series has been proposed.

Such a thermoelectric conversion module has a structure in which the thermoelectric conversion elements are connected in series by electrode portions disposed on one end side and the other end side of a plurality of thermoelectric conversion elements.

In addition, in a case where a temperature difference between one end side and the other end side of the thermoelectric conversion element, electric energy can be generated by the Seebeck effect. Alternatively, by passing an electric current through the thermoelectric conversion element, it is possible to generate a temperature difference between one end side and the other end side of the thermoelectric conversion element due to the Peltier effect.

Here, in a case where the above-described thermoelectric conversion module is disposed in a heat source to obtain electric energy, the state of thermal contact with the heat source is important.

Accordingly, Patent Document 1 discloses that a heat transfer sheet made of graphite is disposed between a heat source and a thermoelectric conversion module.

Patent Document 2 discloses that a heat transfer member made of metal is disposed between a heat source and a thermoelectric conversion module.

### [Citation List]

### [Patent Documents]

[Patent Document 1] Japanese Unexamined Patent Application, First Publication No. 2018-074873
[Patent Literature 2] Japanese Unexamined Patent Application, First Publication No. 2014-127617

### SUMMARY OF INVENTION

### Technical Problem

By the way, in a case where the above-described thermoelectric conversion module is disposed in a heat source having a wide temperature range, heat exhausted from the heat source can be converted into electric energy.

However, a heat transfer sheet made of graphite has not been capable of being used stably in an oxygen-containing atmosphere due to being deteriorated by oxidation, for example, in a case of being used in a high temperature region of 250°C or higher.

A metal having a high melting point can be used in a high temperature region. However, in a case where a member made of metal is disposed, the number of parts increases, and there is concern that stable use may not be possible due to misalignment, coming-off, or the like.

The present invention has been made in consideration of the above-described circumstances, an object of the present invention is to provide a thermoelectric conversion structure that has a relatively simple structure, has good thermal contact with a heat source, and is capable of efficiently converting thermal energy and electric energy.

### Solution to Problem

In order to solve the above problems, a thermoelectric conversion structure of the present invention is characterized by having a heat source and a thermoelectric conversion module installed at the heat source,
in which the thermoelectric conversion module has a plurality of thermoelectric conversion elements, a first electrode portion disposed on one end side of the thermoelectric conversion elements, and a second electrode portion disposed on the other end side of the thermoelectric conversion elements, and has a structure in which the plurality of thermoelectric conversion elements are electrically connected to each other via the first electrode portion and the second electrode portion,
at least a first electrode portion side of the thermoelectric conversion module, facing a heat source direction, has a structure that is free of fixation and free of restraint,
an insulating heat transfer substrate having an insulating layer, a circuit layer made of metal and formed on one surface side of the insulating layer, and a heat transfer layer made of metal and formed on the other surface side of the insulating layer is disposed between the first electrode portion and the heat source, and
the circuit layer has a circuit pattern corresponding to the first electrode portion, and the insulating heat transfer substrate is disposed such that the first electrode portion is in contact with the circuit layer and that the heat transfer layer is in contact with the heat source.

According to the thermoelectric conversion structure of the present invention, the insulating heat transfer substrate having a circuit layer and a heat transfer layer, which are made of metal, is disposed between the first electrode portion and the heat source, and the insulating heat transfer substrate is disposed such that the first electrode portion is in contact with the circuit layer and that the heat transfer layer is in contact with the heat source. As a result, in a case where the heat source and the thermoelectric conversion module are pressurized be in closely attached to each other, the circuit layer and the heat transfer layer, which are made of metal, are deformed, and the thermal contact between the first electrode portion and the circuit layer and the thermal contact between the heat transfer layer and the heat source are good. This makes it possible to sufficiently reduce the thermal resistance at the interface between the first electrode portion and the circuit layer and the interface between the heat transfer layer and the heat source and makes it possible to carry out efficient conversion between the thermal energy and the electric energy.

In addition, since at least a first electrode portion side of the thermoelectric conversion module, facing a heat source direction, has a structure that is free of fixation and free of restraint, and the circuit layer made of metal is in contact with the first electrode portion, it is possible to maintain good thermal contact between the circuit layer and the first electrode portion even in a case where a plurality of thermoelectric conversion elements are thermally expanded individually.

Further, since the insulating heat transfer substrate in which a circuit layer, an insulating layer, and a heat transfer layer are integrated is disposed between the heat source and the thermoelectric conversion module, the number of parts is small and the structure is simplified.

Here, in the thermoelectric conversion structure of the present invention, it is preferable that the circuit layer and the heat transfer layer are formed of any one of the group consisting of aluminum or an aluminum alloy, silver or a silver alloy, and gold or a gold alloy.

In this case, since the aluminum or aluminum alloy, silver or silver alloy, or gold or gold alloy is relatively soft, the circuit layer and the heat transfer layer are easily deformed, and the thermal contact between the first electrode portion and the circuit layer and the thermal contact between the heat transfer layer and the heat source are better in a case where the heat source and the thermoelectric conversion module are pressurized be closely attached to each other.

Further, in a case where the circuit layer and the heat transfer layer are formed of aluminum or an aluminum alloy, silver or a silver alloy, or gold or a gold alloy, it is possible to suppress the deterioration of the circuit layer and the heat transfer layer, and it is possible to use them stably even in a case where they are used under high temperature conditions in an oxygen-containing atmosphere.

Further, in the thermoelectric conversion structure of the present invention, it is preferable that an area of the circuit layer is equal to or larger than an area of the first electrode portion.

In this case, it is possible to maintain good thermal contact between the circuit layer and the first electrode portion even in a case where a plurality of thermoelectric conversion elements are thermally expanded individually, and thus it is possible to carry out efficient conversion between thermal energy and electric energy.

### Advantageous Effects of Invention

According to the present invention, it is possible to provide a thermoelectric conversion structure that has a relatively simple structure, has good thermal contact with a heat source, and is capable of efficiently converting thermal energy and electric energy.

### BRIEF DESCRIPTION OF DRAWINGS

Fig. 1 is a schematic explanatory view of a thermoelectric conversion structure according to an embodiment of the present invention.
Fig. 2 is a schematic explanatory view of a thermoelectric conversion module according to another embodiment according to the present invention, where the thermoelectric conversion module constitutes the thermoelectric conversion structure.
Fig. 3 is a schematic explanatory view of a test device in Example.

### DESCRIPTION OF EMBODIMENTS

Hereinafter, embodiments of the present invention will be described with reference to the accompanying drawings. Each embodiment to be described below is specifically described for a better understanding of the gist of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.

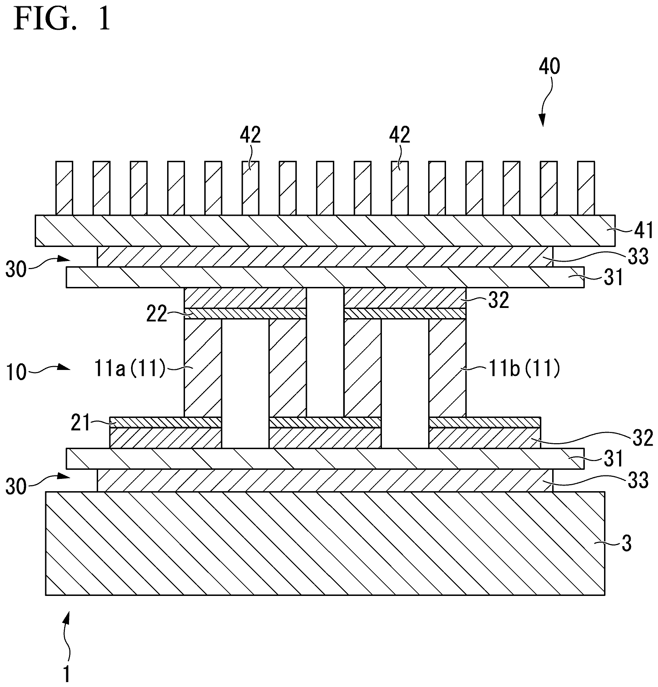

As shown in Fig. 1, a thermoelectric conversion structure 1 according to the present embodiment has a heat source 3, a thermoelectric conversion module 10 installed at this heat source 3, and an insulating heat transfer substrate 30 disposed between the heat source 3 and the thermoelectric conversion module 10.

Here, as shown in Fig. 1, the thermoelectric conversion module 10 includes a plurality of columnar thermoelectric conversion elements 11, and the plurality of columnar thermoelectric conversion elements 11 are electrically connected in series by first electrode portions 21 disposed on one end side (lower side in Fig. 1) of the thermoelectric conversion elements 11 in a longitudinal direction thereof and second electrode portions 22 disposed on the other end side (upper side in Fig. 1) of the thermoelectric conversion elements 11 in the longitudinal direction. Here, the first electrode portions 21 and the second electrode portions 22 are disposed in a pattern, for example, as shown in Fig. 1.

It is noted that in the present embodiment, each of the first electrode portion 21 and the second electrode portion 22 is free of fixation and free of restraint. That is, the thermoelectric conversion module 10 in the present embodiment has a so-called skeleton structure.

In other words, in the present embodiment, each of the first electrode portion 21 and the second electrode portion 22 is arranged to be in contact with the circuit layer 32 but is not joined to a circuit layer 32. As a result, in a case where the heat source 3, the insulating heat transfer substrate 30, and the thermoelectric conversion module 10 are pressurized in the stacking direction, although each of the first electrode portion 21 and the second electrode portion 22 is made to be closely attached to the circuit layer 32 by pressing, whereby a stacked structure of the thermoelectric conversion structure 1 can be temporarily fixed, the space between the first electrode portion 21 and the circuit layer 32 and the space between the second electrode portion 22 and the circuit layer 32 are released in a case where the pressure is released.

The thermoelectric conversion element 11 includes an n-type thermoelectric conversion element 11a and a p-type thermoelectric conversion element 11b, and these n-type thermoelectric conversion element 11a and p-type thermoelectric conversion element 11b are alternately arranged. Metalized layers (not shown in the drawing) are each formed on one end surface and the other end surface of the thermoelectric conversion element 11. As the metalized layer, for example, nickel, silver, cobalt, tungsten, molybdenum, or a nonwoven fabric made of fibers of such metals can be used. It is noted that the outermost surface (the joining surface to the first electrode portion 21 and the second electrode portion 22) of the metalized layer is preferably formed of Au or Ag.

The first electrode portion 21 and the second electrode portion 22 are formed of a material having excellent conductivity, and in the present embodiment, a rolled copper plate is used. It is noted that the above-described metalized layer is joined to the first electrode portion 21 and the second electrode portion 22 by using an Ag wax, an Ag paste, or the like.

It is noted that the thicknesses of the first electrode portion 21 and the second electrode portion 22 are preferably in a range of 0.05 mm or more and 5 mm or less.

The n-type thermoelectric conversion element 11a and the p-type thermoelectric conversion element 11b are formed of, for example, a sintered body of a tellurium compound, a skutterudite, a filled skutterudite, a Heusler, a half-Heusler, a clathrate, a silicide, an oxide, or silicon-germanium.

As a material of the n-type thermoelectric conversion element 11a, for example, Bi₂Te₃, PbTe, La₃Te₄, CoSb₃, FeVAl, ZrNiSn, Ba₈Al₁₆Si₃₀, Mg₂Si, FeSi₂, SrTiO₃, CaMnO₃, ZnO, or SiGe is used.

In addition, as a material of the p-type thermoelectric conversion element 11b, for example, Bi₂Te₃, Sb₂Te₃, PbTe, TAGS (=Ag-Sb-Ge-Te), Zn₄Sb₃, CoSb₃, CeFe₄Sb₁₂, Yb₁₄MnSb₁₁, FeVAl, MnSi_{1.73}, FeSi₂, NaxCoO₂ Ca₃Co₄O₇, Bi₂Sr₂Co₂O₇, or SiGe is used.

It is noted that there are a compound that can take both n-type and p-type by a dopant, and a compound that has only one of n-type and p-type properties.

As shown in Fig. 1, the insulating heat transfer substrate 30 disposed between the thermoelectric conversion module 10 and the heat source 3 has an insulating layer 31, the circuit layer 32 made of metal and formed on one surface side of the insulating layer 31, and a heat transfer layer 33 made of metal and formed on the other surface side of the insulating layer 31.

Here, the insulating layer 31 is preferably formed of a ceramic having excellent insulating properties. For example, aluminum nitride, alumina, or silicon nitride can be applied.

In addition, the thickness of the insulating layer 31 is preferably in a range of, for example, 0.1 mm or more and 2 mm or less.

The circuit layer 32 is formed of a metal having excellent thermal conductivity, and it is preferably formed of, for example, any one of the group consisting of aluminum or an aluminum alloy, silver or a silver alloy, and gold or a gold alloy.

In the present embodiment, the circuit layer 32 is formed of relatively soft aluminum having excellent thermal conductivity and a light weight (for example, 4N aluminum having a purity of 99.99% by mass or more).

In addition, the thickness of the circuit layer 32 is preferably in a range of, for example, 0.05 mm or more and 2 mm or less.

Similar to the circuit layer 32, the heat transfer layer 33 is formed of a metal having excellent thermal conductivity, and it is preferably formed of, for example, any one of the group consisting of aluminum or an aluminum alloy, silver or a silver alloy, and gold or a gold alloy.

In the present embodiment, the heat transfer layer 33 is formed of relatively soft aluminum having excellent thermal conductivity and a light weight (for example, 4N aluminum having a purity of 99.99% by mass or more).

In addition, the thickness of the heat transfer layer 33 is preferably in a range of, for example, 0.05 mm or more and 2 mm or less.

In the insulating heat transfer substrate 30, the circuit layer 32, the insulating layer 31, and the heat transfer layer 33 are joined to be integrated.

The methods of forming the circuit layer 32 and the heat transfer layer 33 are not particularly limited, and an existing joining method such as brazing a metal plate (an aluminum plate) on one surface and the other surface of the insulating layer 31 may be appropriately selected to carry out joining.

Further, the method of forming a circuit pattern of the circuit layer 32 is not particularly limited, and it may be an etching method. Alternatively, metal pieces may be joined in a circuit pattern.

In the present embodiment, as shown in Fig. 1, the above-described insulating heat transfer substrate 30 is also disposed on the other end side of the thermoelectric conversion element 11.

In addition, in the thermoelectric conversion structure 1 of the present embodiment, the insulating heat transfer substrate 30 is disposed between the heat source 3 and the thermoelectric conversion module 10 so that the first electrode portion 21 is in contact with the circuit layer 32 and that the heat transfer layer 33 is in contact with the heat source 3.

The above-described heat source 3, insulating heat transfer substrate 30, and thermoelectric conversion module 10 are fixed in a state of being pressurized in the stacking direction.

Further, a heat sink 40 is disposed on the second electrode portion 22 side of the thermoelectric conversion module 10. The heat sink 40 has a top plate portion 41 stacked on the heat transfer layer 33 of the insulating heat transfer substrate 30, and a fin portion 42 erected from the top plate portion 41. The heat sink 40 is made of a material having high heat transfer properties, for example, aluminum or an aluminum alloy, copper or a copper alloy, or the like.

In this thermoelectric conversion structure 1, the first electrode portion 21 side is arranged in the heat source 3 to become a high temperature portion, the second electrode portion 22 side becomes a low temperature portion due to the heat dissipation by the heat sink 40, and then the conversion between the thermal energy and the electric energy is carried out.

In the thermoelectric conversion structure 1 of the present embodiment, which has the above-described configuration, the insulating heat transfer substrate 30 having the circuit layer 32 and the heat transfer layer 33, which are made of metal, is disposed between the first electrode portion 21 and the heat source 3, and the insulating heat transfer substrate 30 is disposed so that the first electrode portion 21 is in contact with the circuit layer 32 and that the heat transfer layer 33 is in contact with the heat source 3. As a result, in a case where the heat source 3 and the thermoelectric conversion module 10 are pressurized be in closely attached to each other, the circuit layer 32 and the heat transfer layer 33, which are made of metal, are deformed, the thermal contact between the first electrode portion 21 and the circuit layer 32 and the thermal contact between the heat transfer layer 33 and the heat source 3 are good. This makes it possible to sufficiently reduce the thermal resistance at the interface between the first electrode portion 21 and the circuit layer 32 and the interface between the heat transfer layer 33 and the heat source 3 and makes it possible to carry out efficient conversion between the thermal energy and the electric energy.

In addition, since at least the first electrode portion 21 side of the thermoelectric conversion module 10, facing the heat source 3 direction, has a structure that is free of fixation and free of restraint, and the circuit layer 32 made of metal is in contact with the first electrode portion 21, it is possible to maintain good thermal contact between the circuit layer 32 and the first electrode portion 21 even in a case where a plurality of thermoelectric conversion elements 11 are thermally expanded individually.

Further, since the insulating heat transfer substrate 30 in which the circuit layer 32, the insulating layer 31, and the heat transfer layer 33 are integrated is disposed between the heat source 3 and the thermoelectric conversion module 10, the number of parts is small and the structure is simplified.

In the present embodiment, in a case where the circuit layer 32 and the heat transfer layer 33 are formed of any one of the group consisting of aluminum or an aluminum alloy, silver or a silver alloy, and gold or a gold alloy, the circuit layer 32 and the heat transfer layer 33 are easily deformed, and the thermal contact between the first electrode portion 21 and the circuit layer 32 and the thermal contact between the heat transfer layer 33 and the heat source 3 are better in a case where the heat source 3 and the thermoelectric conversion module 10 are pressurized be in closely attached to each other.

Further, it is possible to suppress the deterioration of the circuit layer 32 and the heat transfer layer 33 at an early stage, and it is possible to use them stably even in a case where they are used under high temperature conditions in an oxygen-containing atmosphere.

Further, in the present embodiment, in a case where the facing area of the circuit layer 32 (the area of the surface facing the first electrode portion 21 direction) is set to be equal to or larger than the facing area of the first electrode portion 21 (the area of the surface facing the circuit layer 32 side), the circuit layer 32 is in reliable contact with the first electrode portion 21, it is possible to maintain good thermal contact between the circuit layer 32 and the first electrode portion 21 even in a case where a plurality of thermoelectric conversion elements 11 are thermally expanded individually, and thus it is possible to carry out efficient conversion between thermal energy and electric energy.

Although one embodiment of the present invention has been described above, the present invention is not limited thereto and can be appropriately modified without departing from the technical idea of the invention.

In the present embodiment, although it has been described that each of the first electrode portion 21 and the second electrode portion 22 is not fixed and forms the thermoelectric conversion module having a so-called skeleton structure, and the insulating heat transfer circuit boards 30 are each disposed on the first electrode portion 21 side and the second electrode portion 22 side, the present embodiment is not limited thereto.

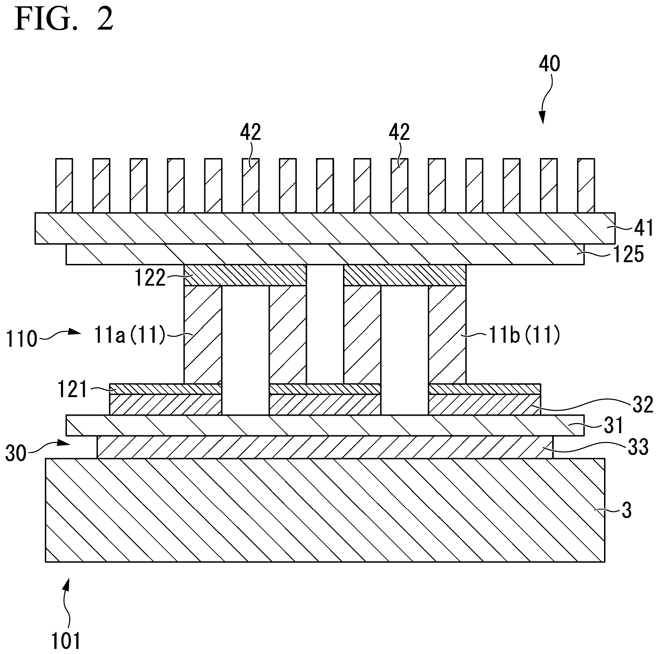

For example, as in a thermoelectric conversion structure 101 shown in Fig. 2, a thermoelectric conversion module 110 may have a half skeleton structure in which a first electrode portion 121 side is not fixed but a second electrode portion 122 is fixed to an insulating board 125.

### [Examples]

A confirmation experiment carried out to confirm the effectiveness of the present invention will be described.

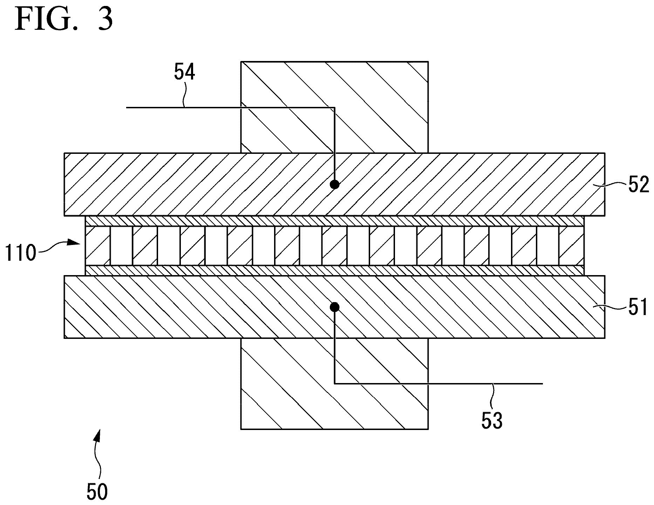

As shown in Fig. 3, a thermoelectric conversion module 110 having a structure in which a plurality of thermoelectric conversion elements are connected in series by the first electrode portion and the second electrode portion was sandwiched between a high temperature side plate 51 and a low temperature side plate 52, and in a state where the thermoelectric conversion module 10 was pressurized at a pressure of 0.5 MPa in the stacking direction by the high temperature side plate 51 and the low temperature side plate 52, the temperature adjustment was carried out so that the temperature of the high temperature side plate 51 was around 150°C, the temperature of the low temperature side plate 52 was around 50°C, and the temperature of the high temperature side plate was around 150°C.

It is noted that the thermoelectric conversion module 110 was arranged so that the first electrode portion faced the high temperature side plate 51 side and the second electrode portion faced the low temperature side plate 52 side. Further, in this experiment, the thermoelectric conversion module 110 having a half skeleton structure in which the first electrode portion side was free of fixation and free of restraint was used.

Here, in the comparative example, an aluminum nitride plate having a thickness of 0.635 mm was disposed between the first electrode portion and the high temperature side plate 51.

On the other hand, in the example of the present invention, an insulating heat transfer substrate in which a circuit layer (thickness: 0.2 mm) made of aluminum (purity: 99.99% by mass) was formed on one surface of the aluminum nitride substrate having a thickness of 0.635 mm, and a heat transfer layer (thickness 0.2 mm) made of aluminum (purity 99.99% by mass) was formed on the other surface of the aluminum nitride substrate was disposed between the first electrode portion and the high temperature side plate 51.

Then, the high temperature side plate 51 and the low temperature side plate 52 were subjected to a temperature adjustment so that the open-circuit voltage became 2.8 V, and the temperatures of the high temperature side plate 51 and the low temperature side plate 52 were actually measured with thermocouples 53 and 54 each embedded in the high temperature side plate 51 and the low temperature side plate 52. Further, the temperature difference between the high temperature side plate 51 and the low temperature side plate 52 was calculated.

**[Table 1]**

| | | High temperature side (°C) | Low temperature side (°C) | Temperature difference (°C) | Open-circuit voltage (V) |
|---|---|---|---|---|---|
| Comparative example | Aluminum nitride plate | 139.5 | 41.4 | 98.0 | 2.8 |
| Example of present invention | Insulating heat transfer substrate | 137.5 | 42.0 | 95.4 | 2.8 |

In a case where the comparative example in which an aluminum nitride plate is disposed between the first electrode portion and the high temperature side plate and the example of the present invention in which an insulating heat transfer substrate is disposed between the first electrode portion and the high temperature side plate are compared, it was confirmed that even in a case where the open-circuit voltage is the same as 2.8V, the temperature difference actually measured is small, and the thermal contact between the high temperature side plate and the first electrode portion is improved in the example of the present invention as compared with the comparative example.

From the above, it was confirmed that according to the example of the present invention, it is possible to provide a thermoelectric conversion structure that has a relatively simple structure, has good thermal contact with a heat source, and is capable of efficiently converting thermal energy and electric energy.

### [Reference Signs List]

1: Thermoelectric conversion structure
3: Heat source
10, 110: Thermoelectric conversion module
11: Thermoelectric conversion element
21: First electrode portion
22: Second electrode portion
30: Insulating heat transfer substrate
31: Insulating layer
32: Circuit layer
33: Heat transfer layer

## Claims

1. A thermoelectric conversion structure comprising:
a heat source; and
a thermoelectric conversion module installed at the heat source,
wherein the thermoelectric conversion module has a plurality of thermoelectric conversion elements, a first electrode portion disposed on one end side of the thermoelectric conversion elements, and a second electrode portion disposed on an other end side of the thermoelectric conversion elements, and has a structure in which the plurality of thermoelectric conversion elements are electrically connected to each other via the first electrode portion and the second electrode portion,
at least a first electrode portion side of the thermoelectric conversion module, facing a heat source direction, has a structure that is free of fixation and free of restraint,
an insulating heat transfer substrate having an insulating layer, a circuit layer made of metal and formed on one surface side of the insulating layer, and a heat transfer layer made of metal and formed on an other surface side of the insulating layer is disposed between the first electrode portion and the heat source, and
the circuit layer has a circuit pattern corresponding to the first electrode portion, and the insulating heat transfer substrate is disposed such that the first electrode portion is in contact with the circuit layer and that the heat transfer layer is in contact with the heat source.

2. The thermoelectric conversion structure according to Claim 1,
wherein the circuit layer and the heat transfer layer are formed of any one of the group consisting of aluminum or an aluminum alloy, silver or a silver alloy, and gold or a gold alloy.

3. The thermoelectric conversion structure according to Claim 1 or 2,
wherein a facing area of the circuit layer is equal to or larger than a facing area of the first electrode portion.
